# FASCICULE DE BREVET EUROPEEN

(11) **EP 2 049 846 B1**
(45) Date de publication et mention de la délivrance du brevet: **27.01.2010**
(21) Numéro de dépôt: 07765766.6
(22) Date de dépôt: 03.07.2007
(51) Int. Cl.: F24J 2/52, F24J 2/06, H01L 31/042

(54) **PLATEFORME SOLAIRE**
SOLARPLATTFORM
SOLAR PLATFORM

(30) Priorité: 29.07.2006 CH 12272006
(43) Date de publication de la demande: 22.04.2009
(73) Titulaire: CSEM Centre Suisse d'Electronique et de Microtechnique SA - Recherche et Développement, 2002 Neuchâtel (CH)
(72) Inventeur: HINDERLING, Thomas, 3011 Bern (CH); ALLANI, Yassine, 1865 Les Diablerets (CH)
(74) Mandataire: GLN
(86) Numéro de dépôt international: PCT/EP2007/056658
(87) Numéro de publication internationale: WO 2008/015064

(56) Documents cités:
- WO-A-2007/122376
- DE-A1- 19 758 309
- DE-A1-102006 003 218
- FR-A- 2 460 400
- US-A- 4 786 795
- US-B1- 7 047 114

## Description

La présente invention se rapporte généralement au domaine de l'exploitation de l'énergie solaire. Elle concerne, plus particulièrement, une plateforme solaire flottante permettant de capter l'énergie solaire de manière optimale, de la convertir et de la stocker.

Plus précisément, l'invention porte sur la recherche d'une solution à la problématique de l'épuisement des ressources d'hydrocarbures et de la fin de l'ère du pétrole à bon marché.

Les systèmes de centrales électro-thermo-solaires, du type « on-shore » nécessitent une grande emprise au sol et sont soumises à différents problèmes tels que : vents de sable entraînant une abrasion accélérée des miroirs ou des panneaux photovoltaïques, cycles d'humidité jour-nuit provoquant un encrassement qui entraîne des coûts de maintenance élevés et une détérioration des surfaces fonctionnelles. De palus, de tels systèmes nécessitent des infrastructures de transport électrique onéreuses. Enfin, la hausse de la température ambiante pénalise l'efficacité énergétiques des cycles thermodynamiques (température de la source froide) et même celle des systèmes photovoltaïques (plus la température de jonction est élevée, plus le rendement diminue).

Ces difficultés peuvent être surmontées en recourant à des plateformes flottant sur un élément liquide. L'une d'elles est décrite, par exemple, dans le document US 4'786795. Elle est dotée de moyens d'orientation lui permettant une réception optimale des rayons du soleil mais elle présente l'inconvénient majeur d'être arrimée au fond, de l'eau, ce qui la rend dépendante des conditions d'ensoleillement locales.

*Le document* DE 197 58 309*. décrit un bateau solaire capable de se diriger, sous les ordres d'un système de navigation, vers des lieux où il peut bénéficier d'un ensoleillement optimum.*

*Certes, le document* US 7 04.7 114 *propose un algorithme d'optimisation des trajectoires d'un navire, mais il ne sert qu'à le protéger contre les risques de collision et de tempête.*

*L'un des bats de la présente invention est de fournir une plateforme solaire flottante «super-intelligente», capable de toujours offrir les meilleures performances.*

*De façon plus précise, l'invention concerne une plateforme solaire flottante comportant un pont relié à des éléments de flottaison, des moyens de captage de l'énergie solaire reçue, associés audit pont et, disposés sur celui-ci, des moyens de conversion de cette énergie, des moyens de stockage du produit de cette conversion et des premiers moyens de propulsion permettant de la déplacer vers des lieux où elle peut bénéficier d'un ensoleillement optimum, des moyens d'asservissement de ses trajectoires, agissant sur lesdits moyens de propulsion et comportant un système de navigation associé* à *un algorithme d'optimisation prédictive de la position en latitude et en longitude, tenant compte de conditions météorologiques locales ou de données logistiques particulières pour un choix optimum de sa localisation, caractérisé en ce que ledit algorithme permet, en plus, de d'ajuster la position de la plateforme en fonction de la date du jour où elle se trouve.*

Selon un premier mode de réalisation avantageux, lesdits moyens de captage sont disposés sur le pont et la plateforme comporte, en outre, des deuxièmes moyens de propulsion pour lui faire subir une rotation gyroscopique selon un axe vertical central afin de maximiser l'apport de l'ensoleillement.

Selon un deuxième mode de réalisation avantageux, la plateforme est associée à des mini plateformes flottantes et lesdits moyens de captage sont disposés sur elles qui comportent alors des deuxièmes moyens de propulsion pour leur faire subir une rotation gyroscopique selon un axe vertical central afin de maximiser l'apport de l'ensoleillement.

D'autres caractéristiques et avantages de l'invention apparaîtront à la lecture de la description qui suit, faite en regard du dessin annexé dans lequel :
- la figure 1 représente une plateforme orientable à positionnement global gyroscopique,
- la figure 2 représente un ensemble constitué d'une plateforme centrale et d'éléments capteurs ou mini plateformes orientables,
- les figures 3 et 4 montrent différentes vues d'un concentrateur extra plat pouvant être utilisé sur les plateformes de l'invention.

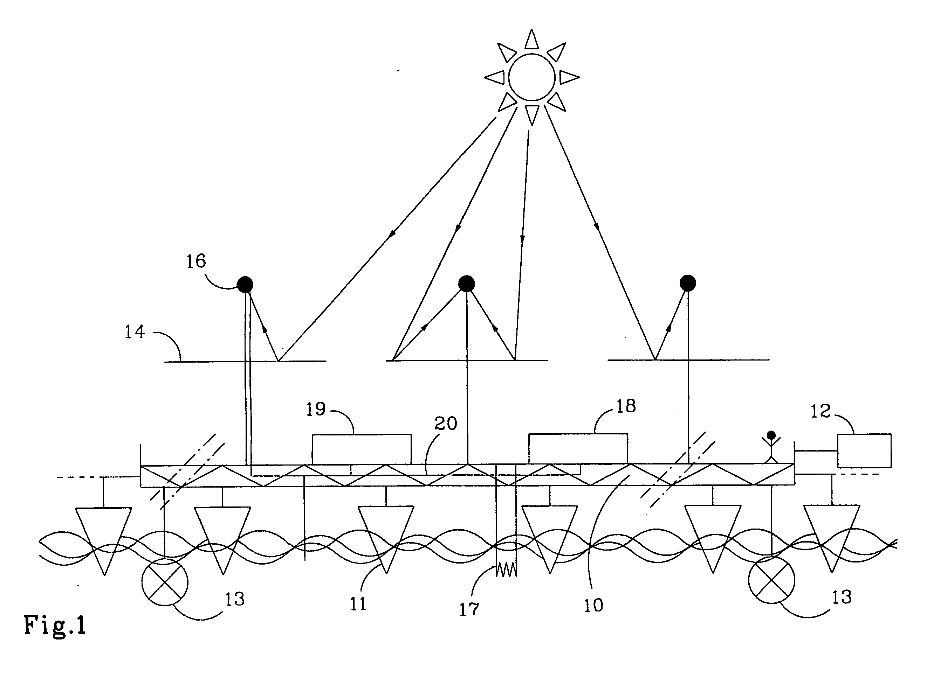

La plateforme représentée schématiquement à la figure 1 a pour base un pont 10 étalé et évidé grâce à des structures triangulées allégées, par exemple, avec traverses croisées Des flotteurs de suspension 11 sont intégrés à ces structures. En variante, cettes-ci peuvent être remplacées par des coussins flottants et légèrement pressurisés.

Des moyens de propulsion 12 permettent de déplacer la plateforme vers des lieux où elle peut bénéficier d'un ensoleillement optimum. Avantageusement, les trajectoires de la plateforme peuvent être asservies par le biais d'un système GPS associé à un algorithme d'optimisation prédictive de la position en latitude et en longitude basé, par exemple, sur la loi de Cook (voir http://fred.elie.free.fr/cadrans_solaires.htm). Par rapport à la solution d'une plateforme maintenue à une position fixe, cette capacité d'ajustement de la position selon la date permet un gain en efficacité (rendement énergétique global) de l'ordre de 15%. L'algorithme d'optimisation peut, de plus, avantageusement tenir compte de conditions météorologiques locales ou de données logistiques particulières pour un choix optimum de la localisation.

La poursuite du soleil dans son mouvement apparent et la stabilisation en position de la plateforme pour contrer l'effetdu vent et des vagues s'effectuent grâce à une rotation gyroscopique de l'ensemble selon un axe vertical central afin de maximiser l'apport de l'ensoleillement. Cette poursuite en rotation est assurée par un jeu d'au moins trois hydro propulseurs 13 (dont deux seulement apparaissent sur le dessin) disposés selon un triangle équilatéral. La poussée de chaque hydro propulseur est asservie, le réglage gyroscopique se faisant, par exemple de manière connue, grâce à trois faisceaux laser avec un positionnement GPS.

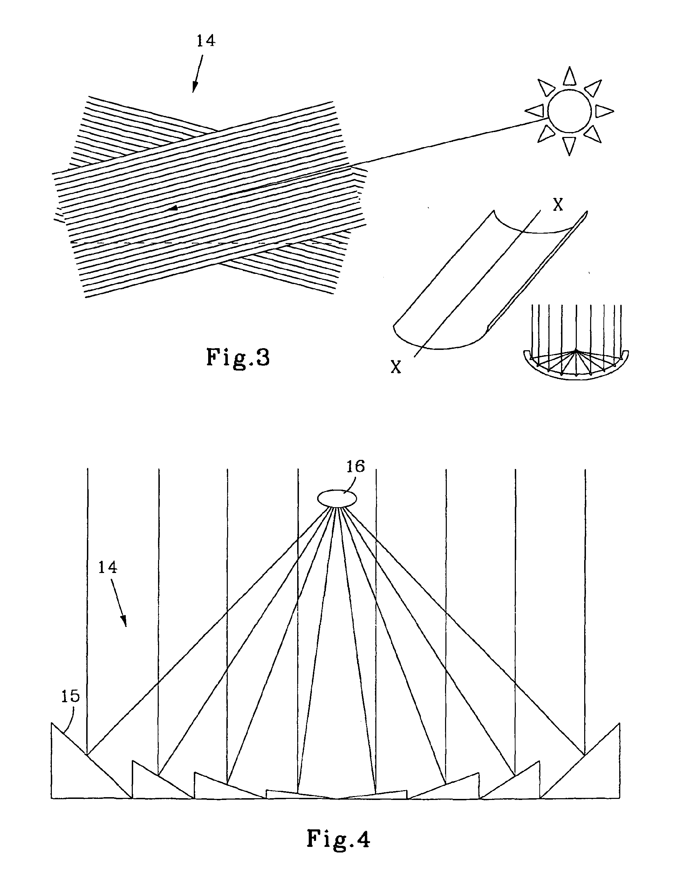

La plateforme est équipée d'une pluralité de concentrateurs 14, par exemple, du type à réflecteur extra plat avantageusement constitué, comme le monstre la figure 3, de lamelles 15 de diverses largeurs et d'angles d'inclinaison différents, qui sont disposées parallèlement et symétriquement par rapport à un axe horizontal XX. L'angle d'inclinaison pour une lamelle d'ordre « i » est la solution d'une équation polynomiale du neuvième degré avec comme variable la tangente du demi angle d'inclinaison. Cette solution maximise l'énergie recueillie au foyer optique 16 du concentrateur lorsque celui-ci coïncide avec son foyer géométrique tout en réduisant l'espace nuisible entre les lamelles.

Le foyer optique 16 du concentrateur est occupé par un tube chaudière horizontal qui reçoit la lumière concentrée de manière directe. Dans une variante de réalisation (non représentée), la réception de la lumière peut se faire moyennant un réflecteur secondaire à doubles miroirs symétriques et à ouverture modulable selon l'heure de la journée. Le but est de maximiser, de manière automatique et auto adaptative, le taux de concentration quelle que soit l'heure de la journée.

Les concentrateurs 14, disposés horizontalement sur la plateforme peuvent être soit fixes, soit pivotants, selon l'axe horizontal XX. Dans le premier cas, les rangées de concentrateurs sont juxtaposées et un très faible espace nuisible les sépare (10% au maximum de la largeur d'une rangée). Dans le deuxième cas, les rangées sont pivotantes, par des moyens appropriés, selon l'axe XX et sont distantes de sorte à tenir compte de l'effet d'ombre (« shadow effect ») mais alors aucun effet de bord n'est provoqué suite au pivotement de la plate forme autour de son axe vertical.

Les lamelles 15 sont fixées sur un support en structure métallique légère grâce à des « clips » évitant toute opération de vissage ou autres pièces rapportées. Ainsi la pose des lamelles et leur «clippage» peuvent être complètement robotisés lors du montage des concentrateurs sur la plateforme. Les lamelles peuvent, avantageusement, contenir une tubulure rassurant leur renforcement longitudinal.

Le tube chaudière disposé au foyer optique 16 permet de convertir l'énergie solaire captée selon les diverses possibilités suivantes :
- production directe d'électricité par utilisation de l'effet thermo photovoltaïque (TPV),
- production directe d'électricité par l'utilisation de cellules photovoltaïques;
- production directe mixte d'électricité (TPV) et de vapeur (« Direct Steam Generation » ou DSG) pour, les cycles thermodynamiques embarqués ;
- production directe mixte d'électricité (TPV) et d'air, chaud pour les cycles thermodynamiques embarqués ;
- production directe de vapeur (DSG) ;
- « production directe d'air chaud pour les cycles dynamiques embarqués ; et
- production directe mixte de vapeur (DSG) et d'air chaud à haute température.

La méthode DSG est assurée à l'aide de tubes coaxiaux incluant une couche de matériau de type « Phase Change Material ou PCM » garantissant une stabilisation de la température de vaporisation. L'injection d'eau garantissant le DSG est assurée à l'aide de valves auto asservies.

Selon une variante, des concentrateurs extra plats à foyer ponctuel peuvent être utilisés en lieu et place des concentrateurs à foyer alinéaire décrits précédemment.

Il va de soi que la présente invention ne se limite pas à l'utilisation de capteurs du type décrit ci-dessus et que d'autres capteurs, tels des cellules photovoltaïques, peuvent avantageusement être utilisées.

Comme le montre la figure 1, la plateforme comporte encore au moins un condenseur 17 immergé dans le fond marin et servant de source froide pour les cycles thermodynamiques, une centrale de puissance 18 pour alimenter des fonctions locales et des moyens 19 de stockage d'énergie sous une forme appropriée (vapeur, H2, aluminium liquide etc.). On notera, enfin, là présence de collecteurs 20 de fluide caloporteur qui retient les tubes chaudières aux différents éléments précités.

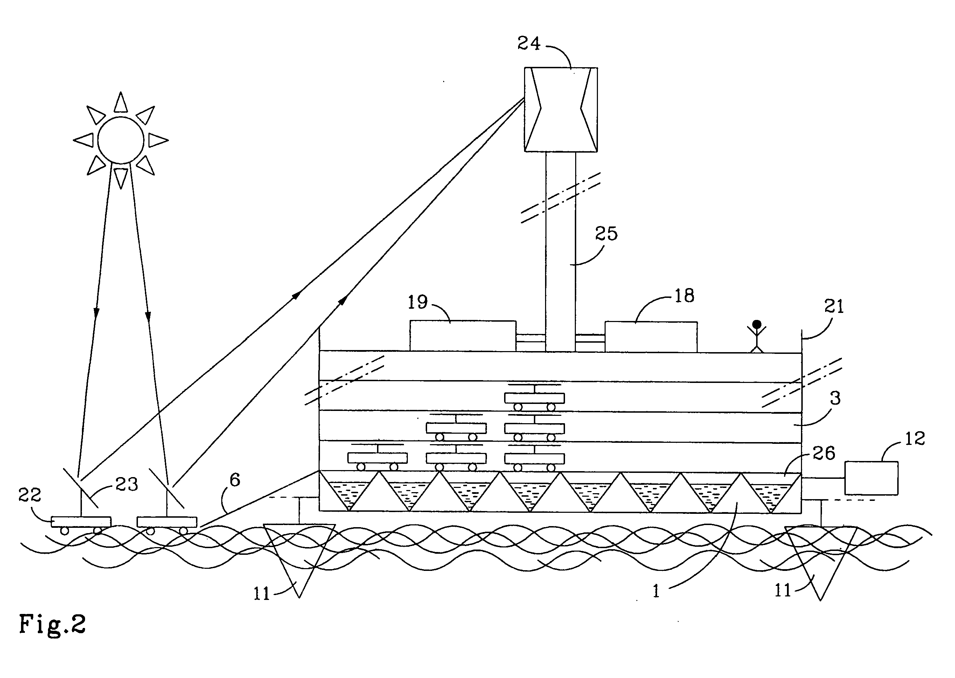

On se réfèrera maintenait à, la figure 2 dans laquelle les éléments identiques à ceux de la figure 1 sont indiqués par les mêmes numéros de référence. Dans ce mode de réalisation, un pont central 21 sans capacité de rotation sur lui-même est associé à une pluralité de mini plateformes flottantes 22 qui portent des concentrateurs 23 identiques à ceux de la figure 3. Les mini plateformes sont capables de s'orienter de manière autonome de même que les lamelles des concentrateurs, comme décrit précédemment. La lumière reçue par les concentrateurs 23 est dirigée vers un foyer chaudière 24 disposé au sommet d'une tour 25 de la plate forme 21 et destiné à opérer la conversion d'énergie comme les tubes chaudières de la figure 1. La plate forme est avantageusement agencée pour stocker les mini plateformes 22 lorsqu'elles ne sont pas en service ou pour te transport. Enfin, le fond de la plateforme constitue un réservoir d'eau servant de condensateur pour le cycle vapeur et, accessoirement, d'unité de dessalement.

En plus des fonctions précédemment énumérées, la plateforme selon l'invention permet de développer des activités non énergétiques telles que la production de chlore par simple électrolyse de l'eau de mer nécessaire à la production d'hydrogène, les activités d'aquaculture et agro-alimentaires liées à la pêche, le transport d'eau potable produite par dessalement ou tout autre moyen.

Ainsi est proposée une plateforme solaire flottante capable, à la fois, de se déplacer vers une localisation idéale, de s'orienter elle-même et orienter ses capteurs en vue d'une exposition optimale aux rayons du soleil. Les différents types décrits de conversion du rayonnement et de stockage de l'énergie font de cette plate forme un outil particulièrement performant et de coût de fabrication (énergie grise) fortement réduit par rapport aux centrales solaires terrestre.

## Revendications

1. *Plateforme solaire flottante comportant un pont (10, 21) relié à des éléments de flottaison (11), des moyens de captage (14, 23) de l'énergie solaire reçue, associés audit pont et, disposés sur celui-ci, des moyens de conversion de cette énergie (16, 24), des moyens de stockage (19) du produit de cette conversion et des premiers moyens de propulsion (12) permettant de la déplacer vers des lieux où elle peut bénéficier d'un ensoleillement optimum, des moyens d'asservissement de ses trajectoires, agissant sur lesdits moyens de propulsion et, comportant un système de navigation associé à un algorithme d'optimisation prédictive de la position en latitude et en longitude, tenant compte de conditions météorologiques locales ou de données logistiques particulières pour un choix optimum de sa localisation,* ***caractérisée en* ce *que*** *ledit algorithme, permet, en plus, d'ajuster la position de la plateforme en fonction de la date du jour* où elle *se trouve.*

2. Plateforme selon la revendication 1, **caractérisée en ce que** lesdits moyens de captage (14) sont disposés sur le pont (10) et **en ce qu'**elle comporte, en outre, des deuxièmes moyens de propulsion (13) pour lui faire subir une rotation gyroscopique selon un axe vertical central afin de maximiser l'apport de l'ensoleillement.

3. Plateforme selon la revendication 1, **caractérisée en ce qu'**elle est associée à des mini plateformes flottantes (22), **en ce que** lesdits moyens de captage (23) sont disposés sur elles et **en ce qu'**elles comportent des deuxièmes moyens de propulsion pour leur faire subir une rotation gyroscopique selon un axe vertical central afin de maximiser l'apport de l'ensoleillement.

4. Plateforme selon l'une des revendications 2 et 3, **caractérisée en ce que** lesdits deuxièmes moyens de propulsion comportent des hydro propulseurs contrôlés par un système GPS.

5. Plateforme selon l'une des revendications précédentes, **caractérisée en ce que** lesdits moyens de captage comportent des cellules photovoltaïques.

6. Plateforme selon l'une des revendications 1 à 5, **caractérisée en ce que** lesdits moyens de captage comportent des concentrateurs (14) à foyer alinéaire.

7. Plateforme selon la revendication 6, **caractérisée en ce que** lesdits concentrateurs (14) sont constitués de lamelles (15) de diverses largeurs et d'angles d'inclinaison différents, qui sont disposées parallèlement et symétriquement par rapport à un axe horizontal (XX).

8. Plateforme selon la revendication 7, **caractérisée en ce que** lesdits concentrateurs sont fixes.

9. Plateforme selon la revendication 7, **caractérisée en ce que** lesdits concentrateurs sont pivotants de manière à recevoir un maximum d'ensoleillement en évitant tout effet d'ombre.

10. Plateforme selon l'une des revendications 6 à 9, **caractérisée en ce que** lesdits moyens de conversion sont constitués par un tube chaudière, disposé au foyer (16) desdits concentrateurs.

11. Plateforme selon l'une des revendications 1 à 5, **caractérisée en ce que** lesdits moyens de captage comportent des concentrateurs (14) à foyer ponctuel.

12. Plateforme selon la revendication 11, **caractérisée en ce que** lesdits moyens de conversion sont constitués par une chaudière (24), disposée au foyer (16) desdits concentrateurs.

13. Plateforme selon l'une des revendications précédentes, **caractérisée en ce** lesdits moyens de conversion sont adaptés à la réalisation d'au moins une des fonctions suivantes :
- production directe d'électricité par utilisation de l'effet thermo photovoltaïque (TPV), le tube étant revêtu d'une couche photovoltaïque ;
- production directe mixte d'électricité (TPV) et de vapeur (« Direct Steam Generation » ou DSG) pour les cycles thermodynamiques embarqués ;
- production directe mixte d'électricité (TPV) et d'air chaud pour les cycles thermodynamiques embarqués ;
- production directe de vapeur (DSG) ;
- production directe d'air chaud pour les cycles dynamiques embarqués ; et
- production directe mixte de vapeur (DSG) et d'air chaud à haute température.

## Claims

1. A floating solar platform comprising a bridge (10, 21) linked to buoyancy elements (11), collector means (14, 23) associated with said bridge to collect received solar energy, and arranged on the latter, means (16,24) for converting this energy, means (19) for storing the product of this conversion and first propelling means (12) for moving the platform to locations where it may benefit from optimum sunlight, means to control its travel path which act on said propelling means and comprise a navigation system associated with a predictive algorithm for optimization of latitude and longitude positioning, having regard to local weather conditions or to particular logistic data for optimum choice of location, **characterized in that** said algorithm further enables adjustment of the platform's position in relation to the day's date at the location in which it lies.

2. The platform according to claim 1, **characterized in that** said collector means (14) are arranged on the bridge (10) and **in that** it also comprises second propelling means (13) for causing it to undergo gyroscopic rotation about a central vertical axis to maximize received sunlight.

3. The platform according to claim 1, **characterized in that** it is associated with floating mini-platforms (22), **in that** said collector means (23) are arranged thereupon and **in that** they comprise second propelling means for causing them to undergo gyroscopic rotation about a central vertical axis to maximize received sunlight.

4. The platform according to either of claims 2 and 3, **characterized in that** said propelling means comprise hydro-propellers controlled by a GPS system.

5. The platform according to any of the preceding claims, **characterized in that** said collector means comprise photovoltaic cells.

6. The platform according to any of claims 1 to 5, **characterized in that** said collector means comprise concentrators (14) having a line focus.

7. The platform according to claim 6, **characterized in that** said concentrators (14) consist of flat plates (15) of various widths and different tilt angles, which are arranged parallel and symmetrically relative to a horizontal axis (XX).

8. The platform according to claim 7, **characterized in that** said concentrators are fixed.

9. The platform according to claim 7, **characterized in that** said concentrators may pivot so as to receive maximum sunlight whilst avoiding any shadow effect.

10. The platform according to any of claims 6 to 9, **characterized in that** said conversion means consist of a boiler tube arranged at the spot focus (16) of said concentrators.

11. The platform according to any of claims 1 to 5, **characterized in that** said collector means comprise concentrators (14) having a point focus.

12. The platform according to claim 11, **characterized in that** said conversion means consist of a boiler (24) arranged at the spot focus (16) of said concentrators.

13. The platform according to any of the preceding claims, **characterized in that** said conversion means are adapted for performing at least one of the following functions:
- direct production of electricity through use of the thermophotovoltaic effect (TPV), the tube being coated with a photovoltaic layer;
- combined direct production of electricity (TPV) and steam (Direct Steam Generation - DSG) for onboard thermodynamic cycles;
- combined direct production of electricity (TPV) and hot air for onboard thermodynamic cycles;
- direct steam generation (DSG);
- direct production of hot air for onboard dynamic cycles; and
- combined direct production of steam (DSG) and hot air at high temperature.

## Patentansprüche

1. Schwimmende Solarplattform, umfassend eine Brücke (10, 21), die mit Schwimmelementen (11) verbunden ist, Mittel (14, 23) zum Auffangen der empfangenen Sonnenenergie, die mit der Brücke verknüpft sind, und auf dieser angeordnet Mittel (16, 24) zum Umwandeln dieser Energie, Mittel (19) zum Speichern des Erzeugnisses dieser Umwandlung und erste Antriebsmittel (12), die es ermöglichen, sie bis zu Stellen zu verschieben, an denen sie eine optimale Sonneneinstrahlung ausnutzen kann, Mittel zum Regeln ihrer Bewegungsbahnen, die auf die Antriebsmittel einwirken und ein Navigationssystem umfassen, das mit einem Optimierungsalgorithmus verknüpft ist, der die Position in geografischer Breite und Länge vorhersagt und dabei die örtlichen Wetterbedingungen oder bestimmte logistische Daten für eine optimale Auswahl ihrer Aufstellung berücksichtigt, **dadurch gekennzeichnet, dass** es der Algorithmus zudem ermöglicht, die Position der Plattform je nach dem Datum, an dem sie sich befindet, zu verstellen.

2. Plattform nach Anspruch 1, **dadurch gekennzeichnet, dass** die Auffangmittel (14) auf der Brücke (10) angeordnet sind, und dass sie ferner zweite Antriebsmittel (13) umfasst, um sie in eine gyroskopische Drehung gemäß einer mittleren senkrechten Achse zu versetzen, um den Beitrag der Sonneneinstrahlung zu maximieren.

3. Plattform nach Anspruch 1, **dadurch gekennzeichnet, dass** sie mit schwimmenden Miniplattformen (22) verknüpft ist, dass die Auffangmittel (23) auf diesen angeordnet sind, und dass diese zweite Antriebsmittel umfassen, um sie in eine gyroskopische Drehung gemäß einer mittleren senkrechten Achse zu versetzen, um den Beitrag der Sonneneinstrahlung zu maximieren.

4. Plattform nach einem der Ansprüche 2 und 3, **dadurch gekennzeichnet, dass** die zweiten Antriebsmittel von einem GPS-System gesteuerte Wassertriebwerke umfassen.

5. Plattform nach einem der vorhergehenden Ansprüche, **dadurch gekennzeichnet, dass** die Auffangmittel Photovoltaikzellen umfassen.

6. Plattform nach einem der Ansprüche 1 bis 5, **dadurch gekennzeichnet, dass** die Auffangmittel Konzentratoren (14) mit linearem Brennpunkt umfassen.

7. Plattform nach Anspruch 6, **dadurch gekennzeichnet, dass** die Konzentratoren (14) aus Lamellen (15) mit verschiedenen Breiten und unterschiedlichen Neigungswinkeln bestehen, die im Verhältnis zu einer waagerechten Achse (XX) parallel und symmetrisch angeordnet sind.

8. Plattform nach Anspruch 7, **dadurch gekennzeichnet, dass** die Konzentratoren feststehend sind.

9. Plattform nach Anspruch 7, **dadurch gekennzeichnet, dass** die Konzentratoren verschwenkbar sind, um eine maximale Sonneneinstrahlung zu empfangen und dabei Schatteneffekte zu vermeiden.

10. Plattform nach einem der Ansprüche 6 bis 9, **dadurch gekennzeichnet, dass** die Umwandlungsmittel aus einem Heizrohr bestehen, das am Brennpunkt (16) der Konzentratoren angeordnet ist.

11. Plattform nach einem der Ansprüche 1 bis 5, **dadurch gekennzeichnet, dass** die Auffangmittel Konzentratoren (14) mit punktförmigem Brennpunkt umfassen.

12. Plattform nach Anspruch 11, **dadurch gekennzeichnet, dass** die Umwandlungsmittel aus einem Heizkessel (24) bestehen, der im Brennpunkt (16) der Konzentratoren angeordnet ist.

13. Plattform nach einem der vorhergehenden Ansprüche, **dadurch gekennzeichnet, dass** die Umwandlungsmittel zum Ausführen mindestens einer der folgenden Funktionen geeignet sind:
- direkte Stromerzeugung durch Verwendung des Thermophotovoltaikeffekts (TPV), wobei das Rohr mit einer photovoltaischen Beschichtung beschichtet ist;
- kombinierte direkte Erzeugung von Strom (TPV) und Dampf ("Direct Steam Generation", bzw. DSG) für die thermodynamischen Bordzyklen;
- kombinierte direkte Erzeugung von Strom (TPV) und Heißluft für die thermodynamischen Bordzyklen;
- direkte Dampferzeugung (DSG);
- direkte Heißlufterzeugung für die thermodynamischen Bordzyklen; und
- kombinierte direkte Erzeugung von Dampf (DSG) und Heißluft auf Hochtemperatur.
